# FASCICULE DE BREVET EUROPEEN

(11) **EP 3 182 287 B1**
(45) Date de publication et mention de la délivrance du brevet: **16.10.2019**
(21) Numéro de dépôt: 16197332.6
(22) Date de dépôt: 04.11.2016
(51) Int. Cl.: G06F 11/30, G06F 11/00

(54) **PROCEDE ET SYSTEME DE CONTROLE DE LA FIABILITE D'AU MOINS UN EQUIPEMENT ELECTRONIQUE INSTALLE DANS UN AERONEF**
VERFAHREN UND VORRICHTUNG DER ZUVERLÄSSIGSKEITÜBERWACHUNG EINES ELEKTRONISCHEN GERÄTS IN EINEM FLUGZEUG
A METHOD AND A SYSTEM FOR MONITORING THE RELIABILITY OF AT LEAST ONE PIECE OF ELECTRONIC EQUIPMENT INSTALLED IN AN AIRCRAFT

(30) Priorité: 18.12.2015 FR 1502641
(43) Date de publication de la demande: 21.06.2017
(73) Titulaire: Airbus Helicopters, 13725 Marignane Cedex (FR)
(72) Inventeur: BAILLY, Stéphane, 13480 CABRIES (FR); SCHMIDT, Vincent, 13100 AIX EN PROVENCE (FR)
(74) Mandataire: GPI & Associés

(56) Documents cités:
- CN-A- 102 184 292
- US-A1- 2008 172 268
- US-A1- 2008 313 501
- US-A1- 2014 181 595
- US-A1- 2014 188 405
- LOPEZ I ET AL: "A review of uncertainty in flight vehicle structural damage monitoring, diagnosis and control: Challenges and opportunities", PROGRESS IN AEROSPACE SCIENCES, OXFORD, GB, vol. 46, no. 7, 1 octobre 2010 (2010-10-01), pages 247-273, XP027218802, ISSN: 0376-0421 [extrait le 2010-05-11]

## Description

La présente invention concerne le domaine de la fiabilité des équipements ou sous-équipements électroniques dans un aéronef tel que notamment un avion ou un giravion. De tels équipements ou sous-équipements électroniques peuvent comporter un ou plusieurs composants électroniques tels que des puces, des micro-processeurs ou des cartes électroniques. De tels équipements ou sous-équipements électroniques peuvent également consister en un ou plusieurs composants électroniques tels que des puces, des micro-processeurs ou des cartes électroniques.

De tels équipements électroniques sont alors sujets à des pannes ou à des dysfonctionnements aléatoires empêchant toute action préventive de remplacement. La maintenance de ces équipements électroniques est donc effectuée de façon corrective lorsqu'une panne aléatoire survient. Ainsi, il est primordial pour un constructeur d'aéronefs d'utiliser des équipements électroniques dont la fiabilité prévisionnelle est maîtrisée.

Par l'expression de fiabilité prévisionnelle, on entend désigner une fiabilité déterminée par calcul en amont d'une exploitation d'un équipement électronique au moyen d'un modèle de fiabilité pour des conditions fonctionnelles et environnementales prédéterminées.

Ainsi, une telle fiabilité prévisionnelle correspond à une estimation d'une probabilité de panne obtenue par calcul en fonction de certaines conditions fonctionnelles d'un équipement électronique ou de certaines conditions environnementales.

L'invention vise donc plus précisément un procédé et un système de contrôle permettant d'une part de réaliser une mesure des conditions environnementales et fonctionnelles d'un tel équipement électronique lors de son fonctionnement et d'autre part de déterminer une fiabilité escomptée pour cet équipement électronique dans des conditions environnementales et fonctionnelles vérifiables.

La fiabilité escomptée est donc quant à elle le résultat attendu donné par un modèle de fiabilité paramétrable par les conditions fonctionnelles et environnementales, lorsque le modèle est alimenté par les paramètres vus par l'équipement électronique.

Par ailleurs, la fiabilité observée d'un équipement électronique correspond à une fiabilité déterminée à partir d'une mesure d'un intervalle de temps de fonctionnement entre deux pannes successives du même composant.

De façon générale dans le domaine aéronautique et tel que notamment décrit dans les documents XP 027218802 (« A review of uncertainty in flight vehicle structural damage monitoring, diagnosis and control : Challenges and opportunities », LOPEZ I ET AL), US 2014/188405 A1, US 2008/313501 A1 et US 2008/172268 A1, il est connu de déterminer la fiabilité observée d'un équipement électronique pour la comparer avec une fiabilité prévisionnelle. Cependant, une telle comparaison ne peut pas être adaptée en fonction des conditions environnementales et fonctionnelles d'un tel équipement électronique lors de son fonctionnement.

Il est par conséquent impossible avec la grande majorité des procédés de contrôle de la fiabilité actuellement connus de déterminer si un écart entre la fiabilité observée et la fiabilité prévisionnelle d'un équipement électronique est dû à par exemple un problème de conception de l'équipement électronique, d'un composant de cet équipement électronique ou bien au contraire des conditions environnementales et fonctionnelles d'un tel équipement électronique lors de son fonctionnement.

Le document US 2014/181595 A1 décrit quant à lui un procédé de contrôle de la fiabilité d'une unité de stockage de type SSD. Il décrit l'utilisation d'un capteur environnemental permettant d'effectuer un modèle de fiabilité en fonction d'une utilisation réelle de l'unité de stockage.

Cependant, dans le document US 2014/181595 A1 l'unité de stockage n'est pas décrite comme étant un équipement électronique installé dans un aéronef. De plus, rien n'indique également qu'une fiabilité est déterminée à partir de données de pannes transmises par un opérateur lors du remplacement d'un équipement électronique.

En outre, il n'est également pas décrit le calcul particulier d'une fiabilité observée obtenue à partir notamment de ces données de pannes, puis sa comparaison avec une fiabilité escomptée et encore moins la génération d'un signal d'alerte si cette fiabilité observée est inférieure à la fiabilité escomptée calculée notamment en fonction des variations d'au moins un paramètre d'état P et d'une fiabilité prévisionnelle.

La présente invention a alors pour objet de proposer un procédé de contrôle adapté au domaine des équipements électroniques d'aéronefs permettant de s'affranchir des limitations mentionnées ci-dessus.

En effet premièrement, un tel procédé de contrôle permet d'identifier un écart entre la fiabilité observée et la fiabilité escomptée d'un équipement électronique.

Deuxièmement, le procédé de contrôle permet d'alerter automatiquement une personne ou une équipe d'un service spécialisé lors de l'occurrence de cet écart entre la fiabilité observée et la fiabilité escomptée de l'équipement électronique.

Enfin troisièmement, le procédé de contrôle permet de faciliter l'identification de la cause d'un éventuel écart entre la fiabilité observée et la fiabilité escomptée de l'équipement électronique.

L'invention concerne donc un procédé de contrôle pour contrôler la fiabilité d'un ou de plusieurs types d'équipements électroniques installés dans une flotte d'aéronefs.

Un tel procédé de contrôle est remarquable en ce qu'il met en oeuvre pour chaque type d'équipements électroniques:
- une étape de surveillance permettant de mesurer des variations d'au moins un paramètre d'état P en fonction du temps t, le ou les paramètres d'état P mesurés lors de l'étape de surveillance du procédé de contrôle étant choisis parmi le groupe comportant au moins la température environnante, l'humidité environnante, la pression atmosphérique environnante, le taux de salinité de l'air environnant, le taux de pollution de l'air environnante, le niveau vibratoire, la tension électrique d'alimentation, la mise sous/hors tension électrique et la forme des signaux d'entrée/de sortie des équipements électroniques,
- une étape de concaténation permettant de générer des groupes de données {tᵢ, Pᵢ, Sⱼ} formés respectivement chacun par :
   ∘ un instant tᵢ représentatif d'un paramètre temporel d'échantillonnage de l'étape de surveillance du procédé de contrôle,
   ∘ une valeur Pᵢ du au moins un paramètre d'état P mesurée à l'instant tᵢ,
   ∘ un numéro d'identification Sⱼ propre à chaque équipement électronique,
- une étape de transmission pour transmettre les données tᵢ, Pᵢ, Sⱼ à une unité centralisée permettant de réaliser une collecte et un enregistrement d'un ensemble de groupes de données {tᵢ, Pᵢ, Sⱼ} en provenance des aéronefs de la flotte,
- une collecte et un enregistrement dans l'unité centralisée de l'ensemble de groupes de données {tᵢ, Pᵢ, Sⱼ},
- une première étape de calcul permettant de déterminer une fiabilité observée F_{obs} du ou des types d'équipements électroniques pour la flotte d'aéronefs à partir d'une part de l'ensemble E de groupes de données {tᵢ, Pᵢ, Sⱼ} collectés et enregistrés dans l'unité centralisée et d'autre part de données de pannes Dₚ générées lors du remplacement d'un équipement électronique défectueux,
- une seconde étape de calcul permettant de déterminer une fiabilité escomptée F_{esc} du ou des types d'équipements électroniques pour la flotte d'aéronefs à partir d'une part de l'ensemble E de groupes de données {tᵢ, Pᵢ, Sⱼ} collectés et enregistrés dans l'unité centralisée et d'autre part d'une fiabilité prévisionnelle Fₚᵣₑᵥ déterminée par calcul en amont d'une exploitation du ou des types d'équipements électroniques sur la flotte d'aéronefs,
- une étape de comparaison pour comparer la fiabilité escomptée F_{esc} du ou des types d'équipements électroniques avec la fiabilité observée F_{obs} du ou des types d'équipements électroniques,
- une étape d'alerte pour alerter lorsque la fiabilité observée F_{obs} du ou des types d'équipements électroniques est inférieure à la fiabilité escomptée F_{esc} du ou des types d'équipements électroniques.

Autrement dit, l'étape de surveillance fournit une pluralité de valeurs Pᵢ associées à un instant tᵢ et représentatives d'une évolution dans le temps t du paramètre d'état P. Ces valeurs Pᵢ et ces instants tᵢ sont ensuite associés à un numéro d'identification Sⱼ propre à un unique équipement électronique.

L'étape de concaténation permet alors de former à partir des trois variables Pᵢ, tᵢ et Sⱼ des groupes de données {tᵢ, Pᵢ, Sⱼ} pour chacun des équipements électroniques. Une telle étape de concaténation peut être réalisée avant ou après l'étape de transmission pour transmettre les données tᵢ, Pᵢ, Sⱼ à une unité centralisée.

Une fois ces groupes de données {tᵢ, Pᵢ, Sⱼ} concaténés, l'étape de transmission permet de centraliser un ensemble E de groupes de données {tᵢ, Pᵢ, Sⱼ} issus d'une flotte d'aéronefs comprenant le même équipement électronique. L'unité centralisée permet dans ce cas de stocker l'ensemble des groupes de données {tᵢ, Pᵢ, Sⱼ} issus de la flotte d'aéronefs.

En fonction de l'ensemble de groupes de données {tᵢ, Pᵢ, Sⱼ} et d'une fiabilité prévisionnelle Fₚᵣₑᵥ déterminée par calcul en amont d'une exploitation du ou des équipements électroniques, la seconde étape de calcul permet de déterminer une fiabilité escomptée F_{esc} propre à chaque équipement électronique et fonction notamment des valeurs Pᵢ du paramètre d'état. En effet, une première fiabilité escomptée F_{esc1} d'un équipement électronique ayant fonctionné sur une première plage P1 de valeurs Pᵢ peut vraisemblablement être distincte d'une seconde fiabilité escomptée F_{esc2} du même équipement électronique ayant fonctionné sur une seconde plage P2 de valeurs Pᵢ. Une telle fiabilité prévisionnelle Fₚᵣₑᵥ peut notamment être déterminée au moyen d'abaques ou de lois de fiabilité prévisionnelle fournies par un fournisseur de l'équipement électronique. Autrement dit, la fiabilité prévisionnelle Fₚᵣₑᵥ d'un équipement électronique est propre à chaque fournisseur de cet équipement électronique.

La première étape de calcul met quant à elle en oeuvre des lois de calcul pour déterminer la fiabilité observée F_{obs} en fonction d'une part de l'ensemble de groupes de données {tᵢ, Pᵢ, Sⱼ} collectés et enregistrés dans l'unité centralisée et d'autre part de données de pannes Dₚ générées lors du remplacement d'un équipement électronique défectueux.

Ensuite, l'étape de comparaison permet d'effectuer périodiquement et automatiquement des comparaisons entre la fiabilité escomptée F_{esc} et la fiabilité observée F_{obs} propre à chaque équipement électronique. Lorsqu'un écart significatif est détecté entre la fiabilité escomptée F_{esc} et la fiabilité observée F_{obs}, l'étape d'alerte permet d'envoyer automatiquement un message d'alerte par exemple par courrier électronique ou sms, selon l'acronyme anglais "Short Message Service", pour alerter une personne ou une équipe de personnes lorsque la fiabilité observée F_{obs} est inférieure à la fiabilité escomptée F_{esc}.

Bien entendu, un tel signal d'alerte peut également être généré automatiquement à partir d'un écart prédéterminé entre la fiabilité observée F_{obs} et la fiabilité escomptée F_{esc}.

De plus, il est alors possible pour tout équipement électronique d'un aéronef de comparer la fiabilité observée F_{obs} avec la fiabilité escomptée F_{esc} en fonction par exemple de la température environnante, de l'humidité environnante, de la pression atmosphérique environnante, du taux de salinité de l'air environnant, du taux de pollution de l'air environnante, du niveau des vibrations, de la tension électrique d'alimentation, de la mise sous/hors tension électrique et de la forme des signaux d'entrée/de sortie de l'équipement électronique.

Avantageusement, la première étape de calcul permettant de déterminer une fiabilité observée F_{obs} du ou des types d'équipements électroniques peut être obtenue à partir d'une fiabilité observée d'un échantillon F_{ech}, cet échantillon comprenant un nombre limité d'équipements électroniques.

En d'autres termes, la fiabilité observée F_{obs} est dans ce cas obtenue par calcul grâce à un échantillon de quelques dizaines d'équipements électroniques tombés effectivement en panne.

En pratique, le procédé de contrôle peut comporter au moins une étape d'enregistrement permettant d'enregistrer les groupes de données {tᵢ, Pᵢ, Sⱼ} propres à chaque équipement électronique.

De cette manière, pour chaque équipement électronique l'étape d'enregistrement permet de conserver au moins temporairement les groupes de données {tᵢ, Pᵢ, Sⱼ}. Cependant, une telle étape d'enregistrement peut être opérée aussi bien à bord de l'aéronef avant toute étape de transmission des groupes de données {tᵢ, Pᵢ, Sⱼ} à l'unité centralisée ou bien en dehors de l'aéronef après avoir opéré cette étape de transmission des groupes de données {tᵢ, Pᵢ, Sⱼ} à l'unité centralisée.

Selon un premier exemple de réalisation de l'invention, une telle étape d'enregistrement peut être opérée avant l'étape de transmission pour transmettre les groupes de données {tᵢ, Pᵢ, Sⱼ} à l'unité centralisée.

Ainsi, l'étape d'enregistrement est opérée à bord de l'aéronef directement dans une mémoire de l'équipement électronique ou dans une autre mémoire de l'aéronef extérieure à l'équipement électronique. Dans ce cas les groupes de données {tᵢ, Pᵢ, Sⱼ} peuvent être stockés avant d'être transmis ou simplement copiés dans l'unité centralisée.

Cependant selon un second exemple de réalisation de l'invention, l'étape d'enregistrement peut également être opérée après l'étape de transmission pour transmettre les groupes de données {tᵢ, Pᵢ, Sⱼ} à l'unité centralisée.

Dans ce cas, il n'y a pas d'enregistrement des groupes de données {tᵢ, Pᵢ, Sⱼ} à bord de l'aéronef et ces groupes de données {tᵢ, Pᵢ, Sⱼ} sont transmis directement à chaque instant tᵢ à l'unité centralisée externe à l'aéronef qui est connectée à la flotte des aéronefs.

La présente invention a aussi pour objet un système de contrôle pour contrôler la fiabilité d'un ou plusieurs tpes d'équipements électroniques installés dans une flotte d'aéronefs.

Selon l'invention, un tel système de contrôle est remarquable en ce qu'il comporte, pour contrôler chaque type d'équipements électroniques :
- des moyens de surveillance permettant de mesurer des variations d'au moins un paramètre d'état P en fonction du temps t, le ou les paramètres d'état P mesurés lors de l'étape de surveillance du procédé de contrôle étant choisis parmi le groupe comportant au moins la température environnante, l'humidité environnante, la pression atmosphérique environnante, le taux de salinité de l'air environnant, le taux de pollution de l'air environnante, le niveau vibratoire, la tension électrique d'alimentation, la mise sous/hors tension électrique et la forme des signaux d'entrée/de sortie des équipements électroniques,
- des moyens de concaténation permettant de générer des groupes de données {tᵢ, Pᵢ, Sⱼ} formés respectivement chacun par :
   ∘ un instant tᵢ représentatif d'un paramètre temporel d'échantillonnage des moyens de surveillance,
   ∘ une valeur Pᵢ du ou des paramètres d'état P mesurée à l'instant tᵢ,
   ∘ un numéro d'identification Sⱼ propre à chacun du ou des équipements électroniques,
- des moyens de transmission pour transmettre les données tᵢ, Pᵢ, Sⱼ à une unité centralisée permettant de réaliser une collecte et un enregistrement d'un ensemble E de groupes de données {tᵢ, Pᵢ, Sⱼ} en provenance des aéronefs de la flotte,
- une unité centralisée pour collecter et enregistrer l'ensemble de groupes de données {tᵢ, Pᵢ, Sⱼ},
- des premiers moyens de calcul permettant de déterminer une fiabilité observée F_{obs} du ou des types d'équipements électroniques pour la flotte d'aéronefs à partir d'une part de l'ensemble E de groupes de données {tᵢ, Pᵢ, Sⱼ} collectés et enregistrés dans l'unité centralisée et d'autre part de données de pannes Dₚ générées lors du remplacement de l'un ou des équipements électroniques défectueux,
- des seconds moyens de calcul permettant de déterminer une fiabilité escomptée F_{esc} du ou des types d'équipements électroniques pour la flotte d'aéronefs à partir d'une part de l'ensemble E de groupes de données {tᵢ, Pᵢ, Sⱼ} collectés et enregistrés dans l'unité centralisée et d'autre part d'une fiabilité prévisionnelle Fₚᵣₑᵥ déterminée par calcul en amont d'une exploitation du ou des types d'équipements électroniques sur la flotte d'aéronefs,
- des moyens de comparaison pour comparer la fiabilité escomptée F_{esc} du ou des types d'équipements électroniques avec la fiabilité observée F_{obs} du ou des types d'équipements électroniques,
- des moyens d'alerte pour alerter lorsque la fiabilité observée F_{obs} du ou des types d'équipements électroniques est inférieure à la fiabilité escomptée F_{esc} du ou des types d'équipements électroniques.

Autrement dit et comme déjà évoqué, un tel système de contrôle permet de vérifier une fiabilité observée F_{obs} d'un type d'équipements électroniques et de générer automatiquement un signal ou un message d'alerte lorsque la fiabilité observée F_{obs} est inférieure à la fiabilité escomptée F_{esc} du type d"équipement électronique.

Les moyens de surveillance peuvent notamment comporter des organes de mesure liés à l'environnement tels que par exemple des sondes thermosensibles pour mesurer une température, une vitesse de variation de la température ou déterminer un nombre de variations thermiques subies par l'équipement électronique. De même, les moyens de surveillance peuvent comporter des organes de mesure tels des sondes sensibles à la pression atmosphérique, à la salinité ou à la pollution de l'air par exemple.

Les moyens de surveillance peuvent également comporter des organes de mesure liés à l'utilisation de l'équipement tels que par exemple des sondes sensibles à la tension ou l'intensité du courant électrique d'alimentation en énergie électrique de l'équipement électronique pour mesurer une tension électrique ou une intensité, une vitesse de variation de la tension électrique ou de l'intensité ou encore déterminer un nombre de variations de tension électrique ou d'intensité subies par l'équipement électronique. De même, les moyens de surveillance peuvent comporter des organes de mesure tels des sondes sensibles à la forme des signaux d'entrée ou de sortie de l'équipement électronique.

Les moyens de concaténation comprennent quant à eux par exemple un processeur, un circuit intégré, un calculateur, un système programmable, un circuit logique ou un ordinateur dédié ou non à cette fonction de regroupement des données temporelles tᵢ, de valeur Pᵢ et d'identification Sⱼ de l'équipement électronique.

De tels moyens de concaténation sont vraisemblablement agencés sur l'aéronef mais peuvent également être déportés de l'aéronef.

Les moyens de transmission pour transmettre les données tᵢ, Pᵢ, Sⱼ ou les groupes de données {tᵢ, Pᵢ, Sⱼ} à l'unité centralisée peuvent se présenter sous diverses formes.

De tels moyens de transmission peuvent par exemple utiliser une technologie sans fil et sans contact. Ces moyens de transmission peuvent alors comprendre des antennes d'émission et/ou de réception d'un signal de radiofréquence, électromagnétique et/ou optique. Par exemple, une antenne GSM (selon l'acronyme anglais Global System for Mobile) d'émission du signal peut alors être agencée sur l'aéronef pour émettre les groupes de données {tᵢ, Pᵢ, Sⱼ} vers l'unité centralisée. Une antenne GSM de réception du signal est alors agencée au niveau de l'unité centralisée pour recevoir automatiquement les données tᵢ, Pᵢ, Sⱼ ou les groupes de données {tᵢ, Pᵢ, Sⱼ} et les transmettre à l'unité centralisée.

D'autres technologies sans fil et sans contact peuvent également être utilisées telles que notamment celles utilisant des protocoles Wi-Fi, Bluetooth, Sigfox ou Lora.

Selon une autre option, ces moyens de transmission peuvent aussi comporter une interface physique permettant la lecture et la collecte des données contenues dans une mémoire agencée sur l'aéronef. Dans ce cas, une telle interface peut par exemple se présenter sous la forme d'un lecteur de carte mémoire ou d'un port permettant le branchement filaire d'un disque dur, d'un ordinateur ou même de l'équipement électronique lorsque celui-ci comporte une mémoire intégrée permettant le stockage des données tᵢ, Pᵢ, Sⱼ ou des groupes de données {tᵢ, Pᵢ, Sⱼ}.

Les premiers moyens de calcul pour déterminer la fiabilité observée F_{obs} du ou des équipements électroniques peuvent quant à eux se présenter par exemple sous la forme d'un processeur, d'un calculateur, d'un circuit intégré, un système programmable, un circuit logique ou un ordinateur dédié ou non à cette fonction. Les premiers moyens de calcul mettent alors en oeuvre des algorithmes pour calculer la fiabilité observée F_{obs} du ou des équipements électroniques.

De même, les seconds moyens de calcul pour déterminer la fiabilité escomptée F_{esc} du ou des équipements électroniques peuvent également se présenter par exemple sous la forme d'un processeur, d'un calculateur, d'un circuit intégré, un système programmable, un circuit logique ou un ordinateur dédié ou non à cette fonction. Les seconds moyens de calcul mettent alors en oeuvre des algorithmes pour calculer la fiabilité escomptée F_{esc} du ou des équipements électroniques grâce à l'ensemble E de groupes de données {tᵢ, Pᵢ, Sⱼ} et à la fiabilité prévisionnelle Fₚᵣₑᵥ déterminée par calcul en amont d'une exploitation du ou des équipements électroniques sur la flotte d'aéronefs. Une telle fiabilité prévisionnelle Fₚᵣₑᵥ est généralement issues de données transmises par les fournisseurs du ou des équipements électroniques et peuvent ainsi consister en des abaques propres à chaque fournisseur d'équipements électroniques.

De même les moyens de comparaisons et les moyens d'alerte peuvent se présenter par exemple sous la forme d'un processeur, d'un calculateur, d'un circuit intégré, d'un système programmable, d'un circuit logique ou d'un ordinateur dédié ou non à ces fonctions de comparaison et d'alerte. Ces moyens de comparaison et ces moyens d'alerte peuvent alors être formés par un ordinateur confondu avec celui mettant en oeuvre les premiers et seconds moyens de calcul.

En pratique, le ou les paramètres d'état P du système de contrôle peuvent être choisis parmi le groupe comportant par exemple la température environnante, l'humidité environnante, la pression atmosphérique environnante, le taux de salinité de l'air environnant, le taux de pollution de l'air environnante, le niveau vibratoire, la tension électrique d'alimentation, la mise sous/hors tension électrique et la forme des signaux d'entrée/de sortie de l'équipement électronique.

Avantageusement, le système de contrôle peut comporter au moins une mémoire permettant d'enregistrer les groupes de données {tᵢ, Pᵢ, Sⱼ} propres à chaque équipement électronique.

En d'autres termes, à chaque fois qu'une mesure d'une valeur Pᵢ est effectuée par les moyens de surveillance, la mémoire permet d'enregistrer le groupe de données {tᵢ, Pᵢ, Sⱼ} propres à chaque équipement. Par ailleurs, une telle mémoire peut être agencée directement sur l'aéronef comprenant l'équipement électronique ou bien au contraire en dehors de cet aéronef.

Ainsi selon un premier exemple de système de contrôle, cette mémoire peut être agencée sur chacun des aéronefs de la flotte.

Dans ce cas, la mémoire peut alors être agencée à l'intérieur ou à l'extérieur du ou des équipements électroniques.

Ainsi lorsque qu'elle est intégrée à un équipement électronique, la mémoire peut être uniquement dédiée au stockage des groupes de données {tᵢ, Pᵢ, Sⱼ} ou permettre de stocker d'autres données de l'équipement électronique.

En revanche lorsque cette mémoire est agencée en dehors de l'équipement électronique mais sur l'aéronef, la mémoire peut également permettre le stockage de plusieurs groupes de données {tᵢ, Pᵢ, Sⱼ} issus de plusieurs équipements électroniques distincts les uns des autres.

Selon un second exemple de système de contrôle, la mémoire peut également être agencée dans l'unité centralisée en dehors de chacun des aéronefs de la flotte.

De cette manière, aucun groupe de données {tᵢ, Pᵢ, Sⱼ} n'est stocké dans l'aéronef. Un tel second exemple de système de contrôle peut être réalisé lorsque les moyens de transmission comportent des moyens de communication sans fil et sans contact permettant à l'aéronef de constamment émettre des groupes de données {tᵢ, Pᵢ, Sⱼ} vers la mémoire agencée au niveau de l'unité centralisée.

L'invention et ses avantages apparaîtront avec plus de détails dans le cadre de la description qui suit avec des exemples donnés à titre illustratif en référence aux figures annexées qui représentent :
- les figures 1 à 4, des vues schématiques selon différentes variantes de systèmes de contrôle conformes à l'invention, et
- les figures 5 à 8, des logigrammes illustrant différents procédés de contrôle conformes à l'invention.

Les éléments présents dans plusieurs figures distinctes sont affectés d'une seule et même référence.

Comme déjà évoqué, l'invention se rapporte à un système de contrôle de la fiabilité d'au moins un équipement électronique agencé dans un aéronef, tel que notamment un avion ou un giravion.

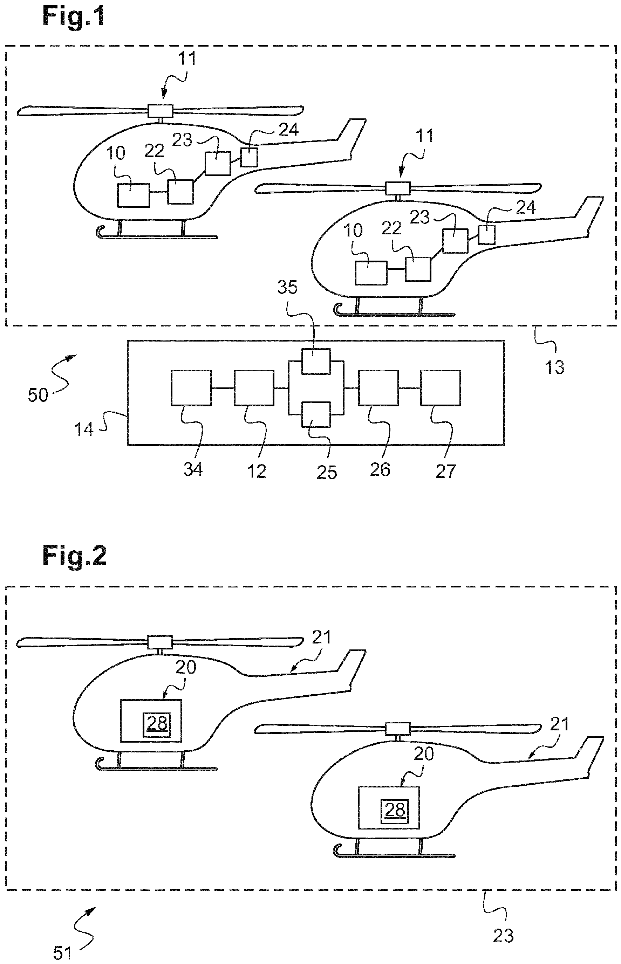

Tel que représenté à la figure 1 selon une première variante, le système de contrôle 50 permet de contrôler la fiabilité d'un équipement électronique 10, agencé dans un même aéronef 11. Le système de contrôle 50 comporte des moyens de surveillance 22 des moyens de concaténation 23 et des moyens de transmission 24 installés dans l'aéronef 11.

Les moyens de surveillance 22 mesurent les variations d'un paramètre d'état P tel que la température régnant dans ou à proximité de l'équipement électronique 10 en fonction du temps t.

Les moyens de concaténation 23 permettent quant à eux de former des groupes de données {tᵢ, Pᵢ, Sⱼ} à partir d'un instant tᵢ représentatif d'un paramètre temporel d'échantillonnage des moyens de surveillance 22, d'une valeur Pᵢ du paramètre d'état P mesurée à l'instant tᵢ et d'un numéro d'indentification Sⱼ propre à l'équipement électronique 10.

Les moyens de transmission 24 permettent de transmettre les données tᵢ, Pᵢ, Sⱼ ou les groupes de données {tᵢ, Pᵢ, Sⱼ} à des moyens de transmission 34 complémentaires agencés dans une unité extérieure 14 agencée en dehors de l'aéronef 11. Une telle unité extérieure 14 comporte alors une unité centralisée 12 pour collecter et enregistrer un ensemble E de groupes de données {tᵢ, Pᵢ, Sⱼ} en provenance d'une flotte 13 d'aéronefs 11.

L'unité extérieure 14 comporte également des premiers moyens de calcul 25 pour déterminer une fiabilité observée F_{obs} de l'équipement électronique 10 pour la flotte 13 d'aéronefs 11 au moyen de l'ensemble E de groupes de données {tᵢ, Pᵢ, Sⱼ} contenus dans l'unité centralisée 12.

L'unité extérieure 14 comporte aussi des seconds moyens de calcul 35 pour déterminer une fiabilité escomptée F_{esc} de l'équipement électronique 10 pour la flotte 13 d'aéronefs 11 à partir d'une part de l'ensemble E de groupes de données {tᵢ, Pᵢ, Sⱼ} collectés et enregistrés dans l'unité centralisée 12 et d'autre part d'une fiabilité prévisionnelle Fₚᵣₑᵥ déterminée par calcul en amont d'une exploitation de l'équipement électronique 10 sur la flotte 13 d'aéronefs 11.

Par ailleurs, l'unité extérieure 14 comporte des moyens de comparaison 26 permettant de comparer la fiabilité observée F_{obs} de l'équipement électronique 10 avec la fiabilité escomptée F_{esc} calculée à partir des groupes de données {tᵢ, Pᵢ, Sⱼ} collectés et de la fiabilité prévisionnelle Fₚᵣₑᵥ qui est quant à elle calculée et transmise par le fabricant ou le fournisseur de l'équipement électronique 10.

Enfin, l'unité extérieure 14 comporte des moyens d'alerte 27 permettant d'alerter une personne ou une équipe de personnes lorsque la fiabilité observée F_{obs} est inférieure à la fiabilité escomptée F_{esc} de l'équipement électronique 10.

Une telle unité extérieure 14 peut par ailleurs être agencée dans des locaux appartenant au fabricant de la flotte 13 d'aéronefs 11, chez un exploitant utilisant la flotte 13 d'aéronefs 11, chez un tiers responsable de la maintenance des équipements électroniques 10 et/ou enfin chez le fabriquant des équipements électroniques 10.

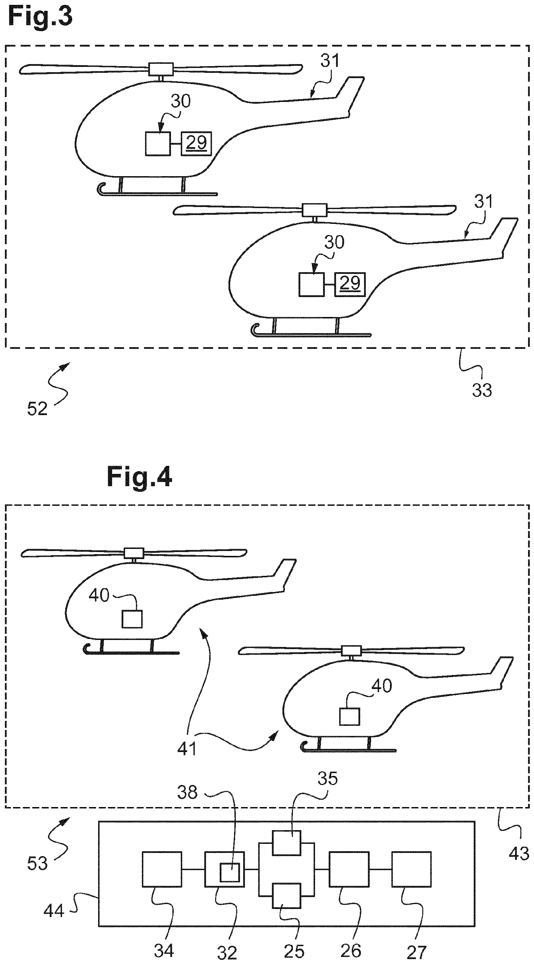

Tel que représenté aux figures 2 à 4, selon trois autres variantes, de tels systèmes de contrôle 51, 52, 53 peuvent également respectivement comporter une mémoire 28, 29, 38 pour enregistrer les groupes de données {tᵢ, Pᵢ, Sⱼ} respectivement propres à chaque équipement électronique 20, 30, 40. Les deuxième et troisième variantes correspondant aux figures 2 et 3 se rapportent au premier exemple de système de contrôle précédemment évoqué dans lequel une mémoire 28, 29 est agencée respectivement sur l'aéronef 21, 31.

Ainsi selon une deuxième variante telle que représentée à la figure 2, le système de contrôle 51 comporte une mémoire 28 agencée dans l'équipement électronique 20. Cet équipement électronique 20 est donc installé dans un aéronef 21 d'une flotte 23 d'aéronefs 21. Les groupes de données {tᵢ, Pᵢ, Sⱼ} sont donc stockés dans la mémoire 28 de l'équipement électronique 20 et peuvent alors ensuite être transmis ou copiés dans une unité centralisée 12.

Selon une troisième variante telle que représentée à la figure 3, le système de contrôle 52 comporte une mémoire 29 agencée dans un aéronef 31 en dehors de l'équipement électronique 30. Comme précédemment, les groupes de données {tᵢ, Pᵢ, Sⱼ} sont donc stockés dans la mémoire 29 de l'aéronef 31 d'une flotte 33 d'aéronefs 31 puis ils sont transmis ou copiés dans une unité centralisée 12.

Enfin, selon une quatrième variante telle que représentée à la figure 4 et correspondant au deuxième exemple de système de contrôle précédemment décrit, le système de contrôle 53 comporte une mémoire 38 agencée dans une unité centrale 32 d'une unité extérieure 44. Dans ce cas, les groupes de données {tᵢ, Pᵢ, Sⱼ} issus des aéronefs 41 de la flotte 43 sont directement transmis à l'unité centralisée 32 sans être stockés dans les aéronefs 41 de la flotte 43. Les moyens de transmissions 34 utilisent donc nécessairement une technologie sans fil et sans contact pour transmettre les groupes de données {tᵢ, Pᵢ, Sⱼ} même lors d'une mission en vol des aéronefs 41 comprenant les équipements électroniques 40.

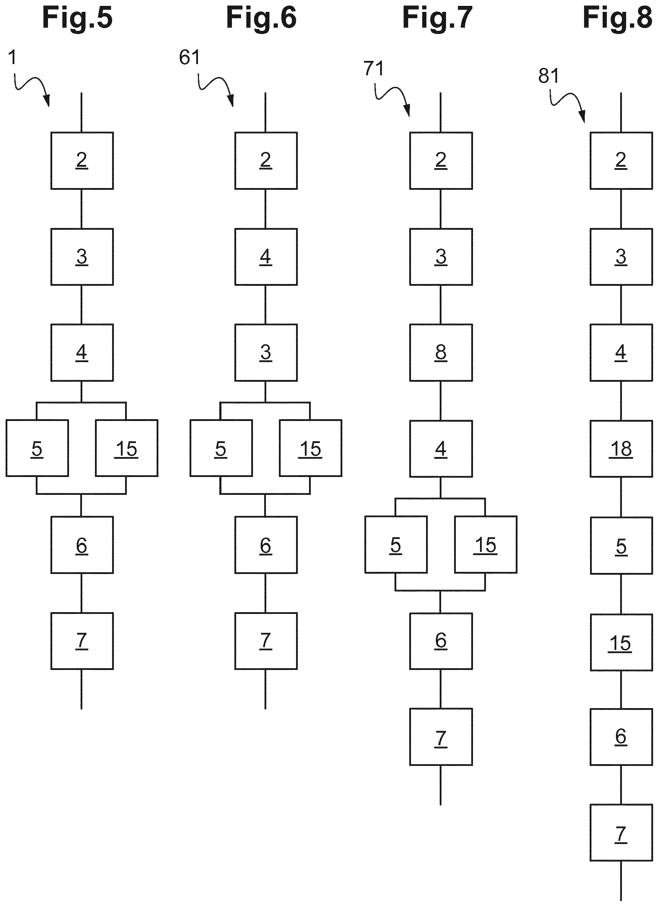

Telle que représentée à la figure 5, l'invention se rapporte également à un procédé de contrôle 1 de la fiabilité d'un équipement électronique 10 agencé dans un aéronef 11, un tel procédé de contrôle 1 comporte une pluralité d'étapes pouvant s'enchainer de manière successive ou en parallèle. Ces étapes comportent ainsi une étape de surveillance 2, une étape de concaténation 3, une étape de transmission 4, une première étape de calcul 5, une seconde étape de calcul 15, une étape de comparaison 6 et une étape d'alerte 7.

Par conséquent, le procédé de contrôle 1 comporte une étape de surveillance 2 pour mesurer des variations d'au moins un paramètre d'état P en fonction du temps t.

Ainsi le procédé de contrôle 1 met en oeuvre également une étape de concaténation 3 pour générer des groupes de données {ti, Pᵢ, Sⱼ} formés par un instant tᵢ représentatif d'un paramètre temporel d'échantillonnage de l'étape de surveillance 2, une valeur Pᵢ du paramètre d'état P mesurée à l'instant tᵢ, un numéro d'identification Sⱼ propre à chaque équipement électronique 10.

En outre, le procédé de contrôle 1 comporte une étape de transmission 4 transmettant les groupes de données {tᵢ, Pᵢ, Sⱼ} à une unité centralisée 12. Une telle unité centralisée 12 permet alors de réaliser une collecte et un enregistrement d'un ensemble E de groupes de données {tᵢ, Pᵢ, Sⱼ} en provenance d'une flotte 13 d'aéronefs 11 comprenant un tel équipement électronique 10.

Telle que représentée à la figure 5, l'étape de de concaténation 3 peut être opérée avant l'étape de transmission. Cependant, selon un autre exemple tel que représenté à la figure 6, le procédé de contrôle 61 peut également comporter une étape de transmission 4 transmettant les données tᵢ, Pᵢ, Sⱼ à une unité centralisée 12 avant de mettre en oeuvre l'étape de concaténation 3 pour générer des groupes de données {tᵢ, Pᵢ, Sⱼ}.

Ensuite, les procédés de contrôle 1 et 61 mettent en oeuvre en parallèle :
- une première étape de calcul 5 pour déterminer une fiabilité observée F_{obs} de l'équipement électronique 10 à partir d'une part de l'ensemble E de groupes de données {tᵢ, Pᵢ, Sⱼ} collectés et enregistrés dans l'unité centralisée 12 et d'autre part de données de pannes Dₚ générées lors du remplacement d'un équipement électronique défectueux 10,
- une seconde étape de calcul 15 pour déterminer une fiabilité escomptée F_{esc} de l'équipement électronique 10 à partir d'une part de l'ensemble E de groupes de données {tᵢ, Pᵢ, Sⱼ} collectés et enregistrés dans l'unité centralisée 12 et d'autre part de la fiabilité prévisionnelle Fₚᵣₑᵥ déterminée par calcul en amont d'une exploitation du ou des équipements électroniques sur la flotte d'aéronefs.

Par ailleurs les procédés de contrôle 1 et 61 comporte respectivement chacun une étape de comparaison 6 permettant de comparer la fiabilité observée F_{obs} de l'équipement électronique 10 avec la fiabilité escomptée F_{esc} de cet équipement électronique 10.

Enfin les procédés de contrôle 1 et 61 mettent en oeuvre une étape d'alerte 7 permettant d'alerter lorsque la fiabilité observée F_{obs} de cet équipement électronique 10 est inférieure à la fiabilité escomptée F_{esc} de cet équipement électronique 10.

Une telle étape d'alerte 7 peut par exemple être mise en oeuvre au moyen d'un envoi d'un message d'alerte transmis à une personne en charge de la surveillance de la fiabilité des équipements électronique 10 d'une flotte 13 d'aéronefs 11. Un tel message d'alerte peut alors notamment se présenter sous la forme d'un sms, d'un mms ou encore d'un courriel.

Tels que représentés aux figures 7 et 8 selon un premier et un second exemples de réalisation d'un procédé de contrôle 71, 81 de la fiabilité d'un équipement électronique 20, 30, 40 agencé dans un aéronef 21, 31, 41, un tel procédé de contrôle 71, 81 peut également comporter une étape d'enregistrement 8, 18 pour enregistrer les groupes de données {tᵢ, Pᵢ, Sⱼ} de chaque équipement électronique 20, 30, 40.

Ainsi tel que représenté à la figure 7 selon le premier exemple de réalisation décrit précédemment, le procédé de contrôle 71 comporte une étape d'enregistrement 8 opérée avant l'étape de transmission 4. Dans ce cas, les groupes de données {tᵢ, Pᵢ, Sⱼ} de chaque équipement 20, 30 peuvent être conservés à bord de l'aéronef 21, 31 et transmis ultérieurement tel que par exemple lors d'une opération de maintenance de l'aéronef 21, 31.

Par ailleurs tel que représenté à la figure 8 selon le deuxième exemple de réalisation décrit ci-dessus, le procédé de contrôle 81 comporte une étape d'enregistrement 18 opérée après l'étape de transmission 4. Dans ce cas, les groupes de données {tᵢ, Pᵢ, Sⱼ} de chaque équipement 40 ne sont pas conservés à bord de l'aéronef 41. Une fois concaténés, ces groupes de données {tᵢ, Pᵢ Sⱼ} sont directement transmis à l'unité centralisée 32 afin de permettre la mise en oeuvre de l'étape de calcul 5.

Tel que représenté à la figure 8, le procédé de contrôle 81 peut mettre en oeuvre successivement l'une après l'autre :
- la première étape de calcul 5 pour déterminer une fiabilité observée F_{obs} de l'équipement électronique 10 à partir d'une part de l'ensemble E de groupes de données {tᵢ, Pᵢ, Sⱼ} collectés et enregistrés dans l'unité centralisée 12 et d'autre part de données de pannes Dₚ générées lors du remplacement d'un équipement électronique défectueux 10, et
- la seconde étape de calcul 15 pour déterminer une fiabilité escomptée F_{esc} de l'équipement électronique 10 à partir d'une part de l'ensemble E de groupes de données {tᵢ, Pᵢ, Sⱼ} collectés et enregistrés dans l'unité centralisée 12 et d'autre part de la fiabilité prévisionnelle Fₚᵣₑᵥ déterminée par calcul en amont d'une exploitation de l'équipement électronique 10 sur la flotte 13 d'aéronefs 11.

Naturellement, la présente invention est sujette à de nombreuses variations quant à sa mise en oeuvre. Bien que plusieurs modes de réalisation aient été décrits, on comprend bien qu'il n'est pas concevable d'identifier de manière exhaustive tous les modes possibles. Il est bien sûr envisageable de remplacer un moyen décrit par un moyen équivalent sans sortir du cadre de la présente invention.

## Revendications

1. Procédé de contrôle (1, 61, 71) pour contrôler la fiabilité d'au moins un type d'équipements électroniques (10, 20, 30, 40) installés dans une flotte (13, 23, 33, 43) d'aéronefs (11, 21, 31, 41), ledit procédé de contrôle (1, 61, 71) met tant en oeuvre pour chaque type d'équipements électroniques (10, 20, 30, 40) :
• une étape de surveillance (2) permettant de mesurer des variations d'au moins un paramètre d'état P en fonction du temps t, ledit au moins un paramètre d'état P étant choisi parmi le groupe comportant la température environnante, l'humidité environnante, la pression atmosphérique environnante, le taux de salinité de l'air environnant, le taux de pollution de l'air environnante, la tension électrique d'alimentation, la mise sous/hors tension électrique et la forme des signaux d'entrée/de sortie desdits équipements électroniques (10, 20, 30, 40),
• une étape de concaténation (3) permettant de générer des groupes de données {tᵢ, Pᵢ, Sⱼ} formés respectivement chacun par :
∘ un instant tᵢ représentatif d'un paramètre temporel d'échantillonnage de l'étape de surveillance (2) du procédé de contrôle (1),
∘ une valeur Pᵢ dudit au moins un paramètre d'état P mesurée à l'instant tᵢ,
∘ un numéro d'identification Sⱼ propre à chacun desdits au moins un équipement électronique (10, 20, 30, 40),
• une étape de transmission (4) pour transmettre lesdites données tᵢ, Pᵢ, Sⱼ à une unité centralisée (12, 32) permettant de réaliser une collecte et un enregistrement d'un ensemble E de groupes de données {tᵢ, Pᵢ, Sⱼ} en provenance desdits aéronefs (11, 21, 31, 41) de ladite flotte (13, 23, 33, 43),
• une collecte et un enregistrement dans ladite unité centralisée (12, 32) dudit ensemble E de groupes de données {tᵢ, Pᵢ, Sⱼ},
• une première étape de calcul (5) permettant de déterminer une fiabilité observée F_{obs} dudit au moins un type d'équipements électroniques (10, 20, 30, 40) pour ladite flotte (13, 23, 33, 43) d'aéronefs (11, 21, 31, 41) à partir d'une part dudit ensemble E de groupes de données {tᵢ, Pᵢ, Sⱼ} collectés et enregistrés dans ladite unité centralisée (12, 32) et d'autre part de données de pannes Dₚ générées lors du remplacement d'un desdits au moins un équipement électronique défectueux (10, 20, 30, 40),
• une seconde étape de calcul (15) permettant de déterminer une fiabilité escomptée F_{esc} dudit au moins un type d'équipements électroniques (10, 20, 30, 40) pour ladite flotte (13, 23, 33, 43) d'aéronefs (11, 21, 31, 41) à partir d'une part dudit ensemble E de groupes de données {tᵢ, Pᵢ, Sⱼ} collectés et enregistrés dans ladite unité centralisée (12, 32) et d'autre part d'une fiabilité prévisionnelle Fₚᵣₑᵥ déterminée par calcul en amont d'une exploitation dudit au moins un type d'équipements électroniques (10, 20, 30, 40) sur la flotte (13, 23, 33, 43) d'aéronefs (11, 21, 31, 41),
• une étape de comparaison (6) pour comparer ladite fiabilité observée F_{obs} dudit au moins un type d'équipements électroniques (10, 20, 30, 40) avec ladite fiabilité escomptée F_{esc} dudit au moins un type d'équipements électroniques (10, 20, 30, 40),
• une étape d'alerte (7) pour alerter lorsque ladite fiabilité observée F_{obs} dudit au moins un type d'équipements électroniques (10, 20, 30, 40) est inférieure à ladite fiabilité escomptée F_{esc} dudit au moins un type d'équipements électroniques (10, 20, 30, 40).

2. Procédé de contrôle selon la revendication 1, dans lequel ladite première étape de calcul (5) permettant de déterminer une fiabilité observée F_{obs} dudit au moins un type d'équipements électroniques (10, 20, 30, 40) est obtenue à partir d'une fiabilité observée d'un échantillon F_{ech}, ledit échantillon comprenant un nombre limité d'équipements électroniques (10, 20, 30, 40).

3. Procédé de contrôle selon l'une quelconque des revendications 1 à 2, dans lequel ledit procédé de contrôle (61, 71) comporte au moins une étape d'enregistrement (8, 18) permettant d'enregistrer lesdits groupes de données {tᵢ, Pᵢ, Sⱼ} propres à chaque équipement (20, 30, 40).

4. Procédé de contrôle selon la revendication 3, dans lequel ladite au moins une étape d'enregistrement (8) est opérée avant ladite étape de transmission (4) pour transmettre lesdits groupes de données {tᵢ, Pᵢ, Sⱼ} à ladite unité centralisée (12).

5. Procédé de contrôle selon la revendication 3, dans lequel ladite au moins une étape d'enregistrement (18) est opérée après ladite étape de transmission (4) pour transmettre lesdits groupes de données {tᵢ, Pᵢ, Sⱼ} à ladite unité centralisée (32).

6. Système de contrôle (50, 51, 52, 53) pour contrôler la fiabilité d'au moins un type d'équipements électroniques (10, 20, 30, 40) installés dans une flotte (13, 253, 33, 43) d'aéronefs (11, 21, 31, 41), dans lequel ledit système de contrôle (50, 51, 52, 53) comporte, pour contrôler chaque type d'équipements électroniques (10, 20, 30, 40):
• des moyens de surveillance (22) permettant de mesurer des variations d'au moins un paramètre d'état P en fonction du temps t, ledit au moins un paramètre d'état P étant choisi parmi le groupe comportant la température environnante, l'humidité environnante, la pression atmosphérique environnante, le taux de salinité de l'air environnant, le taux de pollution de l'air environnante, la tension électrique d'alimentation, la mise sous/hors tension électrique et la forme des signaux d'entrée/de sortie desdits équipements électroniques (10, 20, 30, 40),
• des moyens de concaténation (23) permettant de générer des groupes de données {tᵢ, Pᵢ, Sⱼ} formés respectivement chacun par :
∘ un instant tᵢ représentatif d'un paramètre temporel d'échantillonnage des moyens de surveillance (22),
∘ une valeur Pᵢ dudit au moins un paramètre d'état P mesurée à l'instant tᵢ,
∘ un numéro d'identification Sⱼ propre à chacun desdits au moins un équipement électronique (10, 20, 30, 40),
• des moyens de transmission (24, 34) pour transmettre lesdits groupes de données {tᵢ, Pᵢ, Sⱼ} à une unité centralisée (12, 32) permettant de réaliser une collecte et un enregistrement d'un ensemble E de groupes de données {tᵢ, Pᵢ, Sⱼ} en provenance desdits aéronefs (11, 21, 31, 41) de ladite flotte (13, 23, 33, 43),
• une unité centralisée (12, 32) pour collecter et enregistrer ledit ensemble E de groupes de données {tᵢ, Pᵢ, Sⱼ},
• des premiers moyens de calcul (25) permettant de déterminer une fiabilité observée F_{obs} dudit au moins un type d'équipements électroniques (10, 20, 30, 40) pour ladite flotte (13, 23, 33, 43) d'aéronefs (11, 21, 31, 41) à partir d'une part dudit ensemble E de groupes de données {tᵢ, Pᵢ, Sⱼ} collectés et enregistrés dans ladite unité centralisée (12, 32) et d'autre part de données de pannes Dₚ générées lors du remplacement d'un desdits au moins un équipement électronique défectueux (10, 20, 30, 40),
• des seconds moyens de calcul (35) permettant de déterminer une fiabilité escomptée F_{esc} du ou des types d'équipements électroniques (10, 20, 30, 40) pour ladite flotte (13, 23, 33, 43) d'aéronefs (11, 21, 31, 41) à partir d'une part de l'ensemble E de groupes de données {tᵢ, Pᵢ, Sⱼ} collectés et enregistrés dans ladite unité centralisée (12, 32) et d'autre part d'une fiabilité prévisionnelle Fₚᵣₑᵥ déterminée par calcul en amont d'une exploitation du ou des équipements électroniques (10, 20, 30, 40) sur la flotte (13, 23, 33, 43) d'aéronefs (11, 21, 31, 41),
• des moyens de comparaison (26) pour comparer ladite fiabilité observée F_{obs} dudit au moins un type d'équipements électroniques (10, 20, 30, 40) avec ladite fiabilité escomptée F_{esc} dudit au moins un type d'équipements électroniques (10, 20, 30, 40),
• des moyens d'alerte (27) pour alerter lorsque ladite fiabilité observée F_{obs} dudit au moins un type d'équipements électroniques (10, 20, 30, 40) est inférieure à ladite fiabilité escomptée F_{esc} dudit au moins un type d'équipements électroniques (10, 20, 30, 40).

7. Système de contrôle selon la revendication 6, dans lequel ledit système de contrôle (51, 52, 53) comporte au moins une mémoire (28, 29, 38) permettant d'enregistrer lesdits groupes de données {tᵢ, Pᵢ, Sⱼ} propres à chaque équipement électronique (20, 30, 40).

8. Système de contrôle selon la revendication 7, dans lequel ladite au moins une mémoire (28, 29) est agencée sur chacun desdits aéronefs (21, 31) de la flotte (23, 33).

9. Système de contrôle selon la revendication 8, dans lequel ladite au moins une mémoire (28) est agencée à l'intérieur dudit au moins un équipement électronique (20).

10. Système de contrôle selon la revendication 8, dans lequel ladite au moins une mémoire (29) est agencée à l'extérieur dudit au moins un équipement électronique (30).

11. Système de contrôle selon la revendication 7, dans lequel ladite au moins une mémoire (38) est agencée dans ladite unité centralisée (32) en dehors de chacun desdits aéronefs (41) de la flotte (43).

## Patentansprüche

1. Prüfverfahren (1, 61, 71) zum Überprüfen der Zuverlässigkeit mindestens eines Typs von elektronischen Geräten (10, 20, 30, 40), die in einer Flotte (13, 23, 33, 43) von Luftfahrzeugen (11, 21, 31, 41) installiert sind, wobei das Prüfverfahren (1, 61, 71) für jeden Typ von elektronischen Geräten (10, 20, 30, 40) umfasst:
einen Überwachungsschritt (2), der es erlaubt, Änderungen mindestens eines Zustandsparameters P in Abhängigkeit von der Zeit t zu messen, wobei der mindestens eine Zustandsparameter P aus der Gruppe ausgewählt ist, die die Umgebungstemperatur, die Umgebungsfeuchtigkeit, den Umgebungsluftdruck, den Salzgehalt der Umgebungsluft, den Verschmutzungsgrad der Umgebungsluft, die elektrische Versorgungsspannung, elektrisches Ein-/Ausschalten und die Form der Ein-/Ausgangssignale der elektronischen Geräte (10, 20, 30, 40) umfasst,
einen Verkettungsschritt (3), der es erlaubt, Datensätze {tᵢ, Pᵢ, Sⱼ} zu erzeugen, die jeweils gebildet sind durch:
- einen Zeitpunkt tᵢ, der für einen Abtastzeitparameter des Überwachungsschritts (2) des Prüfverfahrens (1) repräsentativ ist,
- einen Wert Pᵢ des mindestens einen Zustandsparameters P, gemessen zum Zeitpunkt tᵢ,
- eine Identifikationsnummer Sⱼ, die für jedes der mindestens einen elektronischen Geräte (10, 20, 30, 40) einzigartig ist,
einen Übertragungsschritt (4) zum Übertragen der Daten tᵢ, Pᵢ, Sⱼ an eine zentralisierte Einheit (12, 32), die es erlaubt, ein Sammeln und Aufzeichnen einer Menge E von Datensätzen {tᵢ, Pᵢ, Sⱼ} von den Luftfahrzeugen (11, 21, 31, 41) der Flotte (13, 23, 33, 43) durchzuführen,
ein Sammeln und Aufzeichnen der Menge E von Datensätzen {tᵢ, Pᵢ, Sⱼ} in der zentralisierten Einheit (12, 32),
einen ersten Rechenschritt (5), der es erlaubt, eine beobachtete Zuverlässigkeit F_{obs} des mindestens einen Typs von elektronischen Geräten (10, 20, 30, 40) für die Flotte (13, 23, 33, 43) von Luftfahrzeugen (11, 21, 31, 41) einerseits aus der Menge E von in der zentralisierten Einheit (12, 32) gesammelten und aufgezeichneten Datensätzen {tᵢ, Pᵢ, Sⱼ} und andererseits aus beim Ersetzen eines defekten der mindestens einen elektronischen Geräte (10, 20, 30, 40) erzeugten Störungsdaten Dₚ zu bestimmen,
einen zweiten Rechenschritt (15), der es erlaubt, eine erwartete Zuverlässigkeit F_{esc} des mindestens einen Typs von elektronischen Geräten (10, 20, 30, 40) für die Flotte (13, 23, 33, 43) von Luftfahrzeugen (11, 21, 31, 41) einerseits aus der Menge E von in der zentralisierten Einheit (12, 32) gesammelten und aufgezeichneten Datensätzen {tᵢ, Pᵢ, Sⱼ} und andererseits aus einer prädiktiven Zuverlässigkeit Fₚᵣₑᵥ zu bestimmen, die durch Vorausberechnung eines Betriebs des mindestens einen Typs von elektronischen Geräten (10, 20, 30, 40) in der Flotte (13, 23, 33, 43) von Luftfahrzeugen (11, 21, 31, 41) bestimmt wird,
einen Vergleichsschritt (6) zum Vergleichen der beobachteten Zuverlässigkeit F_{obs} des mindestens einen Typs von elektronischen Geräten (10, 20, 30, 40) mit der erwarteten Zuverlässigkeit F_{esc} des mindestens einen Typs von elektronischen Geräten (10, 20, 30, 40),
einen Warnschritt (7) zum Warnen, wenn die beobachtete Zuverlässigkeit F_{obs} des mindestens einen Typs von elektronischen Geräten (10, 20, 30, 40) geringer ist als die erwartete Zuverlässigkeit F_{esc} des mindestens einen Typs von elektronischen Geräten (10, 20, 30, 40).

2. Prüfverfahren nach Anspruch 1,
bei dem der erste Rechenschritt (5), der es erlaubt, eine beobachtete Zuverlässigkeit F_{obs} des mindestens einen Typs von elektronischen Geräten (10, 20, 30, 40) zu bestimmen, aus einer beobachteten Zuverlässigkeit F_{ech} einer Probe erhalten wird, wobei die Probe eine begrenzte Anzahl von elektronischen Geräten (10, 20, 30, 40) umfasst.

3. Prüfverfahren nach einem der Ansprüche 1 bis 2,
bei dem das Prüfverfahren (61, 71) mindestens einen Aufzeichnungsschritt (8, 18) zum Aufzeichnen der für jedes Gerät (20, 30, 40) spezifischen Datensätze {tᵢ, Pᵢ, Sⱼ} umfasst.

4. Prüfverfahren nach Anspruch 3,
bei dem der mindestens eine Aufzeichnungsschritt (8) vor dem Übertragungsschritt (4) zum Übertragen der Datensätze {tᵢ, Pᵢ, Sⱼ} an die zentralisierte Einheit (12) durchgeführt wird.

5. Prüfverfahren nach Anspruch 3,
bei dem der mindestens eine Aufzeichnungsschritt (18) nach dem Übertragungsschritt (4) zum Übertragen der Datensätze {tᵢ, Pᵢ, Sⱼ} an die zentralisierte Einheit (32) durchgeführt wird.

6. Prüfsystem (50, 51, 52, 53) zum Überprüfen der Zuverlässigkeit mindestens eines Typs von elektronischen Geräten (10, 20, 30, 40), die in einer Flotte (13, 253, 33, 43) von Flugzeugen (11, 21, 31, 41) installiert sind,
wobei das Prüfsystem (50, 51, 52, 53) zum Überprüfen jedes Typs von elektronischen Geräten (10, 20, 30, 40) umfasst:
Überwachungsmittel (22), die es erlauben, Änderungen mindestens eines Zustandsparameters P in Abhängigkeit von der Zeit t zu messen, wobei der mindestens eine Zustandsparameter P aus der Gruppe ausgewählt ist, die die Umgebungstemperatur, die Umgebungsfeuchtigkeit, den Umgebungsluftdruck, den Salzgehalt der Umgebungsluft, den Verschmutzungsgrad der Umgebungsluft, die elektrische Versorgungsspannung, elektrisches Ein-/Ausschalten und die Form der Ein-/Ausgangssignale der elektronischen Geräte (10, 20, 30, 40) umfasst,
Verkettungsmittel (23), die es erlauben, Datensätze {tᵢ, Pᵢ, Sⱼ} zu erzeugen, die jeweils gebildet sind durch:
- einen Zeitpunkt tᵢ, der für einen Abtastzeitparameter der Überwachungsmittel (22) des Prüfverfahrens (1) repräsentativ ist,
- einen Wert Pᵢ des mindestens einen Zustandsparameters P, gemessen zum Zeitpunkt tᵢ,
- eine Identifikationsnummer Sⱼ, die für jedes der mindestens einen elektronischen Geräte (10, 20, 30, 40) einzigartig ist,
Übertragungsmittel (24, 34) zum Übertragen der Datensätze {tᵢ, Pᵢ, Sⱼ} an eine zentralisierte Einheit (12, 32), die es erlaubt, ein Sammeln und Aufzeichnen einer Menge E von Datensätzen {tᵢ, Pᵢ, Sⱼ} von den Luftfahrzeugen (11, 21, 31, 41) der Flotte (13, 23, 33, 43) durchzuführen,
eine zentralisierte Einheit (12, 32) zum Sammeln und Aufzeichnen der Menge E von Datensätzen {tᵢ, Pᵢ, Sⱼ},
erste Rechenmittel (25), die es erlauben, eine beobachtete Zuverlässigkeit F_{obs} des mindestens einen Typs von elektronischen Geräten (10, 20, 30, 40) für die Flotte (13, 23, 33, 43) von Luftfahrzeugen (11, 21, 31, 41) einerseits aus der Menge E von in der zentralisierten Einheit (12, 32) gesammelten und aufgezeichneten Datensätzen {tᵢ, Pᵢ, Sⱼ} und andererseits aus beim Ersetzen eines defekten der mindestens einen elektronischen Geräte (10, 20, 30, 40) erzeugten Störungsdaten Dₚ zu bestimmen,
zweite Rechenmittel (35), die es erlauben, eine erwartete Zuverlässigkeit F_{esc} des mindestens einen Typs von elektronischen Geräten (10, 20, 30, 40) für die Flotte (13, 23, 33, 43) von Luftfahrzeugen (11, 21, 31, 41) einerseits aus der Menge E von in der zentralisierten Einheit (12, 32) gesammelten und aufgezeichneten Datensätzen {tᵢ, Pᵢ, Sⱼ} und andererseits aus einer prädiktiven Zuverlässigkeit Fₚᵣₑᵥ zu bestimmen, die durch Vorausberechnung eines Betriebs des oder der elektronischen Geräte (10, 20, 30, 40) in der Flotte (13, 23, 33, 43) von Luftfahrzeugen (11, 21, 31, 41) bestimmt wird,
Vergleichsmittel (26) zum Vergleichen der beobachteten Zuverlässigkeit F_{obs} des mindestens einen Typs von elektronischen Geräten (10, 20, 30, 40) mit der erwarteten Zuverlässigkeit F_{esc} des mindestens einen Typs von elektronischen Geräten (10, 20, 30, 40),
Warnmittel (27) zum Warnen, wenn die beobachtete Zuverlässigkeit F_{obs} des mindestens einen Typs von elektronischen Geräten (10, 20, 30, 40) geringer ist als die erwartete Zuverlässigkeit F_{esc} des mindestens einen Typs von elektronischen Geräten (10, 20, 30, 40).

7. Prüfsystem nach Anspruch 6, bei dem
das Prüfsystem (51, 52, 53) mindestens einen Speicher (28, 29, 38) zum Aufzeichnen der für jedes elektronische Gerät (20, 30, 40) spezifischen Datensätze {tᵢ, Pᵢ, Sⱼ} umfasst.

8. Prüfsystem nach Anspruch 7, bei dem
der mindestens eine Speicher (28, 29) an jedem der Luftfahrzeuge (21, 31) der Flotte (23, 33) angeordnet ist.

9. Prüfsystem nach Anspruch 8, bei dem
der mindestens eine Speicher (28) innerhalb des mindestens einen elektronischen Geräts (20) angeordnet ist.

10. Prüfsystem nach Anspruch 8, bei dem
der mindestens eine Speicher (29) außerhalb des mindestens einen elektronischen Geräts (30) angeordnet ist.

11. Prüfsystem nach Anspruch 7, bei dem
der mindestens eine Speicher (38) in der zentralisierten Einheit (32) außerhalb jedes der Luftfahrzeuge (41) der Flotte (43) angeordnet ist.

## Claims

1. Checking method (1, 61, 71) for checking the reliability of at least one type of electronic device (10, 20, 30, 40) installed in a fleet (13, 23, 33, 43) of aircraft (11, 21, 31, 41), said checking method (1, 61, 71) involving for each type of electronic device (10, 20, 30, 40):
• a monitoring step (2) for measuring variations in at least one state parameter P as a function of time t, said at least one state parameter P being selected from the group including ambient temperature, ambient humidity, ambient atmospheric pressure, ambient air salinity level, ambient air pollution level, supply voltage, connection/disconnection to/from a power supply and input/output signal waveform of said electronic devices (10, 20, 30, 40),
• a concatenation step (3) for generating data groups {tᵢ, Pᵢ, Sⱼ}, each respectively formed of:
o an instant tᵢ representing a time-dependent sampling parameter in the monitoring step (2) of the checking method (1),
∘ a value Pᵢ of said at least one state parameter P measured at instant tᵢ,
∘ an identification number Sⱼ specific to each of said at least one electronic devices (10, 20, 30, 40),
• a transmission step (4) for transmitting said data tᵢ, Pᵢ, Sⱼ to a centralised unit (12, 32) for collecting and recording a set E of data groups {tᵢ, Pᵢ, Sⱼ} from said aircraft (11, 21, 31, 41) of said fleet (13, 23, 33, 43),
• collecting and recording said set E of data groups {tᵢ, Pᵢ, Sⱼ} in said centralised unit (12, 32),
• a first calculation step (5) for determining an observed reliability R_{obs} of said at least one type of electronic device (10, 20, 30, 40) for said fleet (13, 23, 33, 43) of aircraft (11, 21, 31, 41) from, on the one hand, said set E of data groups {tᵢ, Pᵢ, Sⱼ} collected and recorded in said centralised unit (12, 32) and, on the other hand, fault data D_{f} generated when replacing one of said at least one electronic devices (10, 20, 30, 40) that is faulty,
• a second calculation step (15) for determining an expected reliability Rₑₓₚ of said at least one type of electronic device (10, 20, 30, 40) for said fleet (13, 23, 33, 43) of aircraft (11, 21, 31, 41) from, on the one hand, said set E of data groups {tᵢ, Pᵢ, Sⱼ} collected and recorded in said centralised unit (12, 32) and, on the other hand, a predicted reliability R_{pred} calculated prior to operating said at least one type of electronic device (10, 20, 30, 40) in the fleet (13, 23, 33, 43) of aircraft (11, 21, 31, 41),
• a comparison step (6) for comparing said observed reliability R_{obs} of said at least one type of electronic device (10, 20, 30, 40) with said expected reliability Rₑₓₚ of said at least one type of electronic device (10, 20, 30, 40),
• a warning step (7) for warning when said observed reliability R_{obs} of said at least one type of electronic device (10, 20, 30, 40) is less than said expected reliability Rₑₓₚ of said at least one type of electronic device (10, 20, 30, 40).

2. Checking method according to claim 1, wherein said first calculation step (5) for determining an observed reliability R_{obs} of said at least one type of electronic device (10, 20, 30, 40) is obtained from an observed reliability of a sample Rₛₐₘ, said sample comprising a limited number of electronic devices (10, 20, 30, 40).

3. Checking method according to either claim 1 or claim 2, wherein said checking method (61, 71) includes at least one recording step (8, 18) for recording said data groups {tᵢ, Pᵢ, Sⱼ} specific to each device (20, 30, 40).

4. Checking method according to claim 3, wherein said at least one recording step (8) is performed before said transmission step (4) for transmitting said data groups {tᵢ, Pᵢ, Sⱼ} to said centralised unit (12).

5. Checking method according to claim 3, wherein said at least one recording step (18) is performed after said transmission step (4) for transmitting said data groups {tᵢ, Pᵢ, Sⱼ} to said centralised unit (32).

6. Checking system (50, 51, 52, 53) for checking the reliability of at least one type of electronic device (10, 20, 30, 40) installed in a fleet (13, 253, 33, 43) of aircraft (11, 21, 31, 41), wherein said checking system (50, 51, 52, 53), for checking each type of electronic device (10, 20, 30, 40), includes:
• monitoring means (22) for measuring variations in at least one state parameter P as a function of time t, said at least one state parameter P being selected from the group including ambient temperature, ambient humidity, ambient atmospheric pressure, ambient air salinity level, ambient air pollution level, supply voltage, connection/disconnection to/from a power supply and input/output signal waveform of said electronic devices (10, 20, 30, 40),
• concatenation means (23) for generating data groups {tᵢ, Pᵢ, Sⱼ} each respectively formed of:
o an instant tᵢ representing a time-dependent sampling parameter of the monitoring means (22),
o a value Pᵢ of said at least one state parameter P measured at instant tᵢ,
o an identification number Sⱼ specific to each of said at least one electronic devices (10, 20, 30, 40),
• transmission means (24, 34) for transmitting said data groups {tᵢ, Pᵢ, Sⱼ} to a centralised unit (12, 32) for collecting and recording a set E of data groups {ti, Pᵢ, Sj} from said aircraft (11, 21, 31, 41) of said fleet (13, 23, 33, 43),
• a centralised unit (12, 32) for collecting and recording said set E of data groups {tᵢ, Pᵢ, Sⱼ},
• first calculation means (25) for determining an observed reliability R_{obs} of said at least one type of electronic device (10, 20, 30, 40) for said fleet (13, 23, 33, 43) of aircraft (11, 21, 31, 41) from, on the one hand, said set E of data groups {tᵢ, Pᵢ, Sⱼ} collected and recorded in said centralised unit (12, 32) and, on the other hand, fault data D_{f} generated when replacing one of said at least one electronic devices (10, 20, 30, 40) that is faulty,
• second calculation means (35) for determining an expected reliability Rₑₓₚ of the type(s) of electronic devices (10, 20, 30, 40) for said fleet (13, 23, 33, 43) of aircraft (11, 21, 31, 41) from, on the one hand, the set E of data groups {tᵢ, Pᵢ, Sⱼ} collected and recorded in said centralised unit (12, 32) and, on the other hand, a predicted reliability R_{pred} determined by calculation prior to operating the electronic device(s) (10, 20, 30, 40) in the fleet (13, 23, 33, 43) of aircraft (11, 21, 31, 41),
• comparison means (26) for comparing said observed reliability R_{obs} of said at least one type of electronic device (10, 20, 30, 40) with said expected reliability Rₑₓₚ of said at least one type of electronic device (10, 20, 30, 40),
• warning means (27) for warning when said observed reliability R_{obs} of said at least one type of electronic device (10, 20, 30, 40) is less than said expected reliability Rₑₓₚ of said at least one type of electronic device (10, 20, 30, 40).

7. Checking system according to claim 6, wherein said checking system (51, 52, 53) includes at least one memory (28, 29, 38) for recording said data groups {tᵢ, Pᵢ, Sⱼ} specific to each electronic device (20, 30, 40).

8. Checking system according to claim 7, wherein said at least one memory (28, 29) is arranged on each of said aircraft (21, 31) in the fleet (23, 33).

9. Checking system according to claim 8, wherein said at least one memory (28) is arranged inside said at least one electronic device (20).

10. Checking system according to claim 8, wherein said at least one memory (29) is arranged outside said at least one electronic device (30).

11. Checking system according to claim 7, wherein said at least one memory (38) is arranged in said centralised unit (32) outside each of said aircraft (41) in the fleet (43).
